# EUROPÄISCHE PATENTSCHRIFT

(11) **EP 1 155 767 B1**
(45) Veröffentlichungstag und Bekanntmachung des Hinweises auf die Patenterteilung: **13.10.2004**
(21) Anmeldenummer: 01250077.3
(22) Anmeldetag: 09.03.2001
(51) Int. Cl.: B23K 1/012

(54) **Verfahren zum Bestimmen von Stroemungsverhaeltnissen in Reflowloetanlagen und Testplatine**
Method for determining flow conditions in reflow soldering devices and test board
Méthode de determination des conditions de circulation dans une machine à braser par refusion et plaque de test

(30) Priorität: 16.05.2000 DE 10024676
(43) Veröffentlichungstag der Anmeldung: 21.11.2001
(73) Patentinhaber: SIEMENS AKTIENGESELLSCHAFT, 80333 München (DE)
(72) Erfinder: Meier, Hartmut, 16321 Bernau (DE); Mueller, Bernd, 16259 Falkenberg (DE); Wittreich, Ulrich, 16727 Velten (DE)

(56) Entgegenhaltungen:
- PATENT ABSTRACTS OF JAPAN vol. 1998, no. 14, 31. Dezember 1998 (1998-12-31) & JP 10 256722 A (SONY CORP), 25. September 1998 (1998-09-25)

## Beschreibung

Die Erfindung betrifft ein Verfahren zum Bestimmen von Strömungsverhältnissen des Heizgases in Reflowlötanlagen. Beim Reflowlöten wird die für den Lötprozeß notwendige Wärme durch ein erwärmtes Heizgas übertragen, welches die zu verlötenden Körper umströmt. Um einen guten Wärmeübergang zwischen dem Heizgas und den zu verlötenden Körpern und damit eine gleichmäßige Durchwärmung dieser Körper zu erreichen, ist es günstig, mit hohen Gasdurchsätzen, also mit relativ starken Gasströmungen in der Reflowlötanlage zu arbeiten. Mit der Stärke der Gasströmung wächst jedoch die Gefahr, daß z. B. relativ kleine elektrische oder elektronische Bauelemente beim Lötprozeß verrutschen. Diese Gefahr besteht insbesondere dann, wenn zusätzlich zu einer hohen Strömungsgeschwindigkeit des Heizgases eine für die elektrischen Bauelemente ungünstige Strömungsart, wie z. B. eine turbulente Strömung, auftritt.

Um festzustellen, ob die Strömungsverhältnisse den Lötprozeß negativ beeinträchtigen könnten, bietet es sich an, einen kompletten Reflow-Lötvorgang durchzuführen, also eine Platine z. B. per Schablonendruck oder Siebdruck mit Lotpaste zu bedrucken, elektrische Bauelemente auf die Platine aufzusetzen, danach die Platine in der Reflowlötanlage zu löten und zu prüfen, ob die Bauelemente ihre Position beibehalten haben. Dieses Verfahren ist relativ kompliziert und zeitaufwendig und setzt das Vorhandensein von Geräten zum Schablonendruck bzw. Siebdruck und zur Bestückung der Platinen mit den elektrischen Bauelementen voraus.

Der Erfindung liegt die Aufgabe zugrunde, ein Verfahren anzugeben, mit dem auf einfache Art und Weise die Strömungsverhältnisse des Heizgases in Reflowlötanlagen bestimmt werden können.

Diese Aufgabe wird bei einem Verfahren der eingangs angegebenen Art dadurch gelöst, daß eine lotpastenfreie Testplatine mit lotpastenfreien Strömungstestelementen durch die Reflowlötanlage transportiert wird und Bewegungen der Strömungstestelemente zum Bestimmen der Strömungsverhältnisse ausgewertet werden.

Ein wesentlicher Vorteil des erfindungsgemäßen Verfahrens besteht darin, daß sowohl die verwendete Testplatine als auch die Strömungstestelemente lotpastenfrei sind. Daher werden keine Geräte zum Schablonendruck oder Siebdruck benötigt.

In einer vorteilhaften Ausführungsform des erfindungsgemäßen Verfahrens werden als Strömungstestelemente Modellbauelemente verwendet, die in ihrer Form der elektrischer Bauelemente entsprechen und ein Gewicht aufweisen, das eine Haftreibungskraft auf der Testplatine entsprechend der von Lotpaste auf die elektrischen Bauelemente ausgeübten Naßklebekraft zur Folge hat. Durch die Form der Modellbauelemente und die Größe der durch ihr Gewicht erzeugten Haftreibungskraft wird ein Verhalten der Modellbauelemente erreicht, welches bezüglich der Gefahr des Verrutschens während des Transports durch die Reflowlötanlage dem Verhalten von in Verbindung mit Lotpaste eingesetzten elektrischen oder elektronischen Bauelementen entspricht.

In einer weiteren Ausführungsform des erfindungsgemäßen Verfahrens werden als Strömungstestelemente vom Heizgas drehbare Fahnen verwendet. Mit diesen Fahnen ist es möglich, die Art der Strömung (laminare Strömung, turbulente Strömung, veränderliche Strömung) festzustellen.

Vorteilhafterweise können die Bewegungen der Strömungstestelemente während des Transportes der Testplatine durch die Reflowlötanlage mittels eines Bild- oder Filmaufnahmegerätes aufgezeichnet werden. Dies ermöglicht eine Auswertung der Bewegungen der Strömungstestelemente auch nach Abschluß des Transportes der Testplatine durch die Reflowlötanlage sowie eine dauerhafte Aufbewahrung der Testergebnisse in Bild- oder Filmform.

Vorteilhafterweise kann ein Bild- oder Filmaufnahmegerät.verwendet werden, das an der Testplatine befestigt ist. Es wird dann zusammen mit der Testplatine durch die Reflowlötanlage transportiert und ermöglicht auch an von außen schwer einsehbaren Stellen die Auswertung der Bewegungen der Strömungstestelemente.

In einer weiteren Ausführungsform des erfindungsgemäßen Verfahrens werden die Bewegungen der Modellbauelemente mittels einer eine Fläche der Testplatine bildenden Sensorplatte ausgewertet, welche die Lage der Modellbauelemente festzustellen imstande ist. Derartige Sensorplatten werden beispielsweise von der Firma "Carrol Touch", 2800 Oakmont Drive, Round Rock, Texas 78664, USA unter der Bezeichnung "Infrared Flat Panel Touch Frames" oder "Resistive Touch Panel" angeboten; andere derartige Sensorplatten werden auch als "Drucksensitive Oberflächen" bezeichnet. Mit derartigen Sensorplatten können die Lage und die Lageveränderungen (Bewegungen) der Modellbauelemente erfasst und in elektrische Signale umgewandelt werden; die elektrischen Signale können dann beispielsweise unter Benutzung einer mit der Sensorplatte elektrisch verbundenen elektronischen Schaltung (z.B eines Rechners) gespeichert oder ausgewertet werden. Dabei kann die elektronische Schaltung z.B. zusammen mit der Testplatine durch die Reflowlötanlage transportiert werden oder sie kann sich außerhalb der Reflowlötanlage befinden und mit einem Kabel mit der Testplatine verbunden sein. Ebenso kann die Sensorplatte mit einem Sender verbunden sein, der mit der Sensorplatte durch die Reflowlötanlage transportiert wird und der die elektrischen Signale an einen außerhalb der Reflowlötanlage befindlichen Empfänger überträgt. Der Empfänger ist dann mit der oben erwähnten elektronischen Schaltung zur Speicherung oder Auswertung der elektrischen Signale verbunden. In dieser Ausführungsform ist der Einsatz eines Bild- oder Filmaufnahmegeräts nicht notwendig; die elektrischen Signale lassen sich darüber hinaus gut automatisiert auswerten.

Das bisher beschriebene Verfahren kann auch vorteilhafterweise mehrfach hintereinander durchgeführt werden. Dabei wird z.B. in einem ersten Verfahrensablauf eine Testplatine mit Modellbauelementen durch die Reflowlötanlage transportiert und durch Vergleich der Lage der Modellbauelemente vor und nach dem Transport eine Bewegung der Modellbauelemente erkannt. Wenn im ersten Verfahrensablauf Bewegungen der Modellbauelemente erkannt wurden, kann danach in einem zweiten Verfahrensablauf eine Testplatine mit Modellbauelementen und mit an der Testplatine befestigtem Bild- oder Filmaufnahmegerät durch die Reflowlötanlage transportiert werden; dabei kann der Ort innerhalb der Reflowlötanlage, an dem die Bewegung der Modellbauelemente auftritt, bestimmt werden. Im Anschluß daran kann in einem dritten Verfahrensablauf mit einer Testplatine mit Fahnen und mit an der Testplatine befestigtem Bild- oder Filmaufnahmegerät bestimmt werden, welche Art und Ausprägung der Strömung (laminare Strömung, turbulente Strömung, veränderliche Strömung) an dem im zweiten Verfahrensablauf ermittelten Ort innerhalb der Reflowlötanlage, an dem die Bewegung der Modellbauelemente auftrat, vorliegt. Damit ist also der Ort innerhalb der Reflowlötanlage, an dem eine Bewegung der Modellbauelemente auftritt und an dem also die Strömungsverhältnisse den Lötprozess negativ beeinflussen können, sowie die Art und Ausprägung der Strömung an diesem Ort bekannt. Somit können an diesem Ort weitergehende Untersuchungen der Strömung vorgenommen werden; z.B. kann mit richtungsabhängig messenden Strömungs-Messgeräten (z.B. Hitzdraht-Anemometer) die Strömungsgeschwindigkeit gemessen werden.

Der Erfindung liegt die weitere Aufgabe zugrunde, eine Testplatine anzugeben, mit der auf einfache Art und Weise die Strömungsverhältnisse in Reflowlötanlagen bestimmt werden können. Dazu geht die Erfindung von einer Testplatine mit auf einer Seite angeordneten Strömungstestelementen zum Bestimmen von Strömungsverhältnissen des Heizgases in Reflowlötanlagen aus und sieht erfindungsgemäß vor, daß die Testplatine lotpastenfrei ist und lotpastenfreie Strömungstestelemente trägt. Dies hat den Vorteil, daß keine aufwendigen Geräte zum Aufdrucken der Lotpaste erforderlich sind.

Als Strömungstestelemente können Modellbauelemente verwendet werden, die in ihrer Form der elektrischer Bauelemente entsprechen und ein Gewicht aufweisen, das eine Haftreibungskraft auf der Testplatine entsprechend der von Lotpaste auf die elektrischen Bauelemente ausgeübten Naßklebekraft zur Folge hat. Durch Form und Gewicht der Modellbauelemente wird hier bezüglich der Gefahr des Verrutschens während des Transportes durch die Reflowlötanlage das Verhalten von herkömmlichen elektrischen oder elektronischen Bauelementen mit Lotpaste nachgestellt und damit eine den realen Lötverhältnissen entsprechende Situation geschaffen.

Als Strömungstestelemente können vom Heizgas drehbare Fahnen verwendet werden. Diese haben den Vorteil, daß mit ihnen die Strömungsart (laminare Strömung, turbulente Strömung, veränderliche Strömung) ermittelt werden kann.

Vorteilhafterweise kann die Testplatine aus einem durchsichtigen Material bestehen und an der anderen Seite der Testplatine kann ein Bild- oder Filmaufnahmegerät derart angeordnet sein, daß dieses durch die Testplatine hindurch die Bewegungen der Strömungstestelemente aufzuzeichnen imstande ist. Dies hat insbesondere den Vorteil, daß sich das Bild- oder Filmaufnahmegerät bezüglich der Strömungstestelemente auf der anderen Seite der Testplatine befindet und somit die Strömungsverhältnisse auf der Seite der Strömungstestelemente nicht verfälscht.

In einer weiteren vorteilhaften Ausführungsform der Testplatine können auf dieser Markierungen zur Auswertung der Bewegungen der Strömungstestelemente angebracht sein. Diese Markierungen ermöglichen es, auch quantitative Aussagen über die Größe der Bewegungen zu treffen.

Eine weitere vorteilhafte Form der Testplatine ist dadurch gekennzeichnet, dass eine Sensorplatte, welche die Lage der Modellbauelemente festzustellen imstande ist, eine Fläche der Testplatine bildet. Wie oben bereits dargestellt, werden derartige Sensorplatten von der Firma "Carroll Touch" angeboten. Sie bieten den Vorteil, dass Informationen über die Lage und die Lageänderungen der Modellbauelemente direkt in elektrische Signale gewandelt werden und diese elektrischen Signale schnell und relativ einfach auswertbar sind.

Zur weiteren Erläuterung der Erfindung ist in
Figur 1 ein Ausführungsbeispiel einer Testplatine mit Strömungstestelementen und einem Bild- oder Filmaufnahmegerät in Seitenansicht, in
Figur 2 dasselbe Ausführungsbeispiel der Testplatine in einer Draufsicht, in
Figur 3 ein Teil einer Reflowlötanlage mit der Testplatine in Schnittdarstellung, in
Figur 4 ein Ausführungsbeispiel einer Testplatine mit Modellbauelementen in Draufsicht und in
Figur 5 ein Ausschnitt aus der Testplatine mit einem Ausführungsbeispiel eines Modellbauelements in einer Ansicht von schräg oben gezeigt.

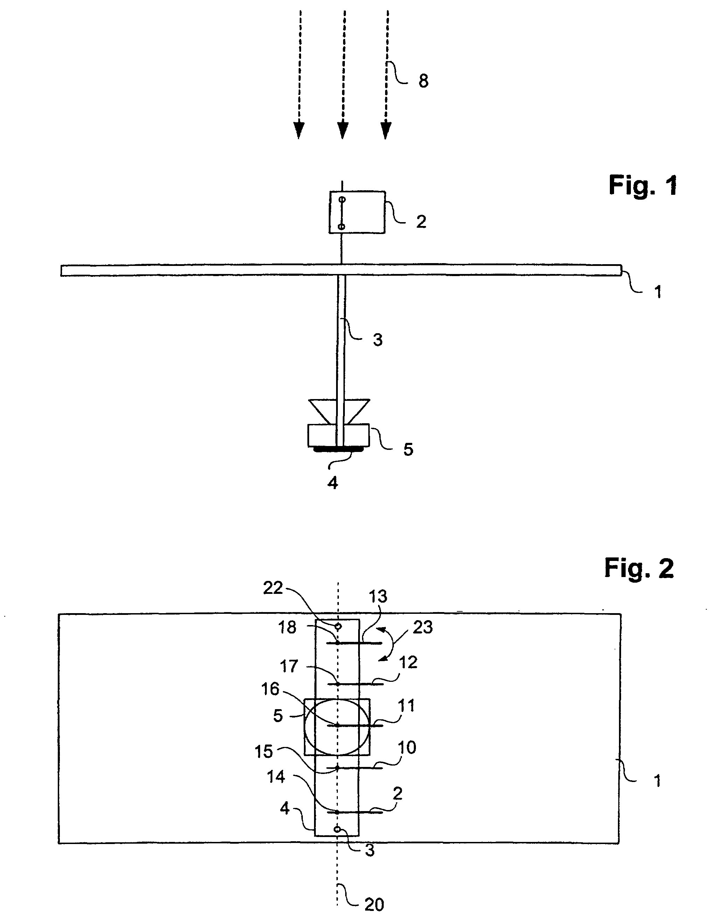

In Figur 1 ist eine Testplatine 1 dargestellt, auf deren einer oberen Seite als Strömungstestelemente drehbar gelagerte Fahnen 2 so montiert sind, dass ihre Drehachsen senkrecht auf der Ebene der Testplatine stehen. Von diesen Fahnen ist hier nur die äußere, dem Betrachter zugewandte Fahne 2 sichtbar. An der anderen Seite der Testplatine ist mit Hilfe eines Geräteträgers 3 und einer an diesem Geräteträger 3 befestigten Auflage 4 ein Bild- oder Filmaufnahmegerät 5 derart befestigt, dass dieses in der Lage ist, durch die aus einem durchsichtigen Material bestehende Testplatine 1 hindurch die Bewegungen der Fahnen aufzuzeichnen. Eine oberhalb der Testplatine 1 auftretende Gasströmung, welche symbolisch durch drei punktierte Pfeile 8 dargestellt ist, bewegt die als Strömungstestelemente dienenden Fahnen 2. Der Geräteträger 3, die Auflage 4 und das Bild- oder Filmaufnahmegerät 5 befinden sich auf der anderen Seite der Testplatine 1, so dass diese die Strömung oberhalb der Testplatine nicht verfälschen. Die Testplatine 1 kann aus einem hitzebeständigen durchsichtigen Material (z.B. Quarzglas) bestehen. Ein ebenfalls hitzebeständiges Bild- oder Filmaufnahmegerät 5 und hitzebeständige Strömungstestelemente vorausgesetzt, kann dann die Testplatine bei normalen Betriebsbedingungen (z.B. Temperatur des Heizgases 250 Grad Celsius) durch die Reflowlötanlage transportiert werden und die Strömungsverhältnisse können bei diesen realen Betriebsbedingungen bestimmt werden. Die Testplatine 1 kann aber auch aus einem nicht hitzebeständigen durchsichtigen Material (z.B. Plexiglas) bestehen. Mit einer derartigen Testplatine können die Strömungsverhältnisse in der Reflowlötanlage bestimmt werden, wenn relativ kaltes Heizgas testweise durch die Reflowlötanlage strömt. Vorteile dieser Ausgestaltung der Testplatine sind geringere Herstellungskosten für die Testplatine und die Möglichkeit, auch ein nicht hitzebeständiges Bild- oder Filmaufnahmegerät 5 und nicht hitzebeständige Strömungstestelemente zu verwenden. Die Alternative, eine aus hitzebeständigem Material oder eine aus nicht hitzebeständigem Material bestehende Testplatine zu verwenden, besteht auch bei den Testplatinen der nachfolgend beschriebenen Figuren, wobei dort auch die entsprechenden, eben genannten Vorteile auftreten.

In Figur 2 ist dasselbe Ausführungsbeispiel der Testplatine 1 in Draufsicht gezeigt. Auf der oberen, dem Betrachter zugewandten Seite der Testplatine 1 sind hier neben der Fahne 2 noch weitere Fahnen 10 bis 13 dargestellt; die Drehachsen 14 bis 18 dieser Fahnen befinden sich entlang einer gedachten Linie 20 über die Breite der Testplatine 1 verteilt. Auf der anderen, vom Betrachter abgewandten Seite der Testplatine 1 ist mit Hilfe des Geräteträgers 3 und eines weiteren Geräteträgers 22 die Auflage 4 befestigt, auf der sich das Bildoder Filmaufnahmegerät 5 befindet. _Mit Hilfe eines Pfeiles 23 ist beispielhaft angedeutet, wie sich die Fahne 13 um ihre Drehachse 18 dreht.

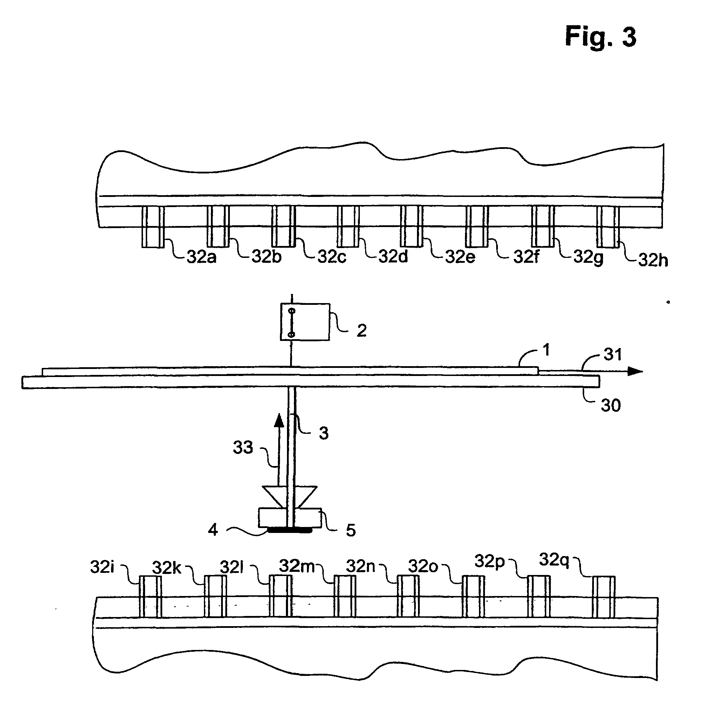

In Figur 3 ist ein Schnitt durch einen Teil einer Reflowlötanlage dargestellt, durch die mittels einer Transportkette 30 die Testplatine 1 mit den Fahnen 2 und dem Bild- oder Filmaufnahmegerät 5 transportiert wird. Die Transportrichtung ist durch einen Pfeil 31 dargestellt. Oberhalb der die Fahnen tragenden Seite der Testplatine 1 sind Gasausströmdüsen 32a bis 32h gezeigt, durch welche das Heizgas in die Reflowlötanlage strömt. Auf der anderen, unteren Seite der Testplatine 1 ist wiederum das an der Testplatine befestigte Bild- oder Filmaufnahmegerät 5 dargestellt. Die Aufnahmerichtung des Bild- oder Filmaufnahmegerätes 5 ist durch einen Pfeil 33 dargestellt; die Bewegungen der Fahnen werden durch das durchsichtige Material der Testplatine 1 hindurch aufgenommen. Die Transportkette 30 verdeckt dabei nur schmale Streifen der Testplatine 1, so dass die Bewegungen der Fahnen in ausreichender Art und Weise aufgenommen werden können. Auf der Seite des an der Testplatine befestigten Bild- oder Filmaufnahmegerätes 5 befinden sich ebenfalls Gasausströmdüsen 32i bis 32q, welche dieselbe Aufgabe wie die Gasausströmdüsen 32a bis 32h haben.

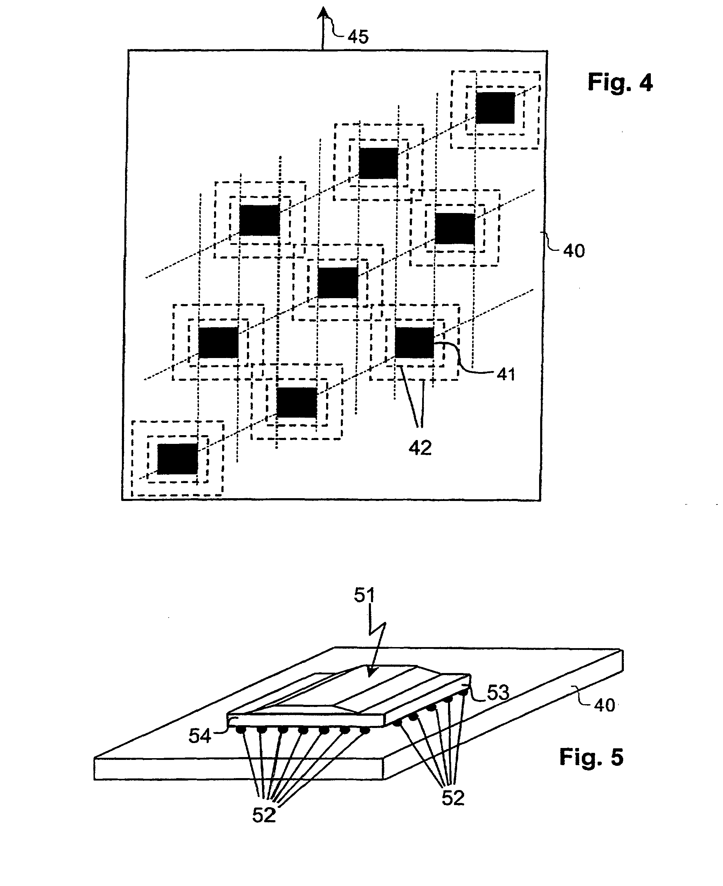

In Figur 4 ist die Draufsicht eines weiteren Ausführungsbeispiel einer Testplatine 40 dargestellt, welche als Strömungstestelemente Modellbauelemente 41 trägt. Die Testplatine 40 kann wie die in Figur 1 dargestellte Testplatine 1 aus einem durchsichtigen Material bestehen; in diesem Fall kann an der unteren, hier nicht sichtbaren Seite der Testplatine ein Bild- oder Filmaufnahmegerät zur Aufzeichnung der Bewegungen der Modellbauelemente beim Transport durch die Reflowlötanlage angebracht sein. Die Testplatine 40 kann aber auch aus einem undurchsichtigen Material bestehen. An ihr ist in diesem Fall kein Bild- oder Filmaufnahmegerät befestigt. In diesem Fall wird vor dem Transport der Testplatine durch die Reflowlötanlage die Lage der Modellbauelemente 41 festgestellt und mit der Lage der Modellbauelemente 41 nach dem Transport durch die Reflowlötanlage verglichen. Es ist daher dann nicht notwendig, die Bewegungen der Modellbauelemente während des Transportes mit einem Bild- oder Filmaufnahmegerät aufzuzeichnen. Auf der dem Betrachter zugewandten Seite der Testplatine 40 sind um die Modellbauelemente 41 herum rechteckförmige Markierungen 42 angebracht, mit deren Hilfe Bewegungen der Modellbauelemente festgestellt und qualitativ und quantitativ ausgewertet werden können. Die Testplatine 40 wird in einer Richtung, wie sie durch den Pfeil 45 dargestellt ist, durch die Reflowlötanlage transportiert. Die Modellbauelemente 41 sind derart auf der Testplatine angeordnet, dass sie die gesamte Breite der Testplatine 40 senkrecht zur Transportrichtung überdecken, abgesehen von zwei schmalen Randstreifen. Dadurch ist sichergestellt, dass die Strömungsverhältnisse an nahezu jedem Punkt der Reflowlötanlage ausgewertet werden können.

In Figur 5 ist ein Ausschnitt aus der Testplatine 40 dargestellt, auf der sich ein spezielles Ausführungsbeispiel eines Modellbauelementes 51 befindet. Das Modellbauelement 51 ist mit seinen Anschlüssen 52 lose auf die Testplatine 40 aufgesetzt und kann somit von einer ausreichend starken, in der Reflowlötanlage herrschenden Strömung bewegt werden. Das Modellbauelement 51 ist hier beispielsweise so entworfen, dass es ein leicht durch eine Gasströmung verschiebbares Bauelement nachbildet. Es stellt also ein bezüglich der Gefahr des Verrutschens ungünstiges Bauelement dar. Es besitzt einen großen Querschnitt und hat eine strömungstechnisch ungünstige Form, da z. B. seine Seitenflächen 53 und 54 eine große Angriffsfläche für die Strömung darstellen. Weiterhin besitzt das Modellbauelement beispielsweise ein geringes Gewicht und eine relativ geringe Auflagefläche, da nur relativ wenige Anschlüsse 52 vorhanden sind.

## Patentansprüche

1. Verfahren zum Bestimmen von Strömungsverhältnissen des Heizgases in Reflowlötanlagen, bei dem
- eine lotpastenfreie Testplatine (1, 40) mit lotpastenfreien Strömungstestelementen (2, 10 bis 13, 41, 51) durch die Reflowlötanlage transportiert wird und
- Bewegungen der Strömungstestelemente (2, 10 bis 13, 41, 51) zum Bestimmen der Strömungsverhältnisse ausgewertet werden.

2. Verfahren nach Anspruch 1, bei dem als Strömungstestelemente Modellbauelemente (41, 51) verwendet werden, die in ihrer Form der elektrischer Bauelemente entsprechen und ein Gewicht aufweisen, das eine Haftreibungskraft auf der Testplatine (1, 40) entsprechend der von Lotpaste auf die elektrischen Bauelemente ausgeübten Naßklebekraft zur Folge hat.

3. Verfahren nach Anspruch 1, bei dem als Strömungstestelemente (2, 10 bis 13, 41, 51) vom Heizgas drehbare Fahnen verwendet werden.

4. Verfahren nach einem der Ansprüche 1 bis 3, bei dem die Bewegungen der Strömungstestelemente (2, 10 bis 13, 41, 51) während des Transportes der Testplatine durch die Reflowlötanlage mittels eines Bild- oder Filmaufnahmegerätes (5) aufgezeichnet werden.

5. Verfahren nach Anspruch 4, bei dem ein Bild- oder Filmaufnahmegerät (5) verwendet wird, das an der Testplatine (1, 40) befestigt ist.

6. Verfahren nach Anspruch 2, bei dem
die Bewegungen der Modellbauelemente mittels einer eine Fläche der Testplatine bildenden Sensorplatte ausgewertet werden, welche die Lage der Modellbauelemente festzustellen imstande ist.

7. Testplatine (1, 40) mit auf einer Seite angeordneten Strömungstestelementen (2, 10 bis 13, 41, 51) zum Bestimmen von Strömungsverhältnissen des Heizgases in Reflowlötanlagen,
**dadurch gekennzeichnet, daß**
die Testplatine (1, 40) lotpastenfrei ist und lotpastenfreie Strömungstestelemente (2, 10 bis 13, 41, 51) trägt, deren Bewegungen während des Transports durch eine Reflowlötanlage zum Bestimmen der Strömungsverhältnisse ausgewertet werden können.

8. Testplatine nach Anspruch 7,
**dadurch gekennzeichnet, daß**
sie als Strömungstestelemente Modellbauelemente (41, 51) aufweist, die in ihrer Form der elektrischer Bauelemente entsprechen und ein Gewicht aufweisen, das eine Haftreibungskraft auf der Testplatine (1, 40) entsprechend der von Lotpaste auf die elektrischen Bauelemente ausgeübten Naßklebekraft zur Folge hat.

9. Testplatine nach Anspruch 7,
**dadurch gekennzeichnet, daß**
sie als Strömungstestelemente vom Heizgas drehbare Fahnen (2, 10 bis 13) aufweist.

10. Testplatine nach einem der Ansprüche 7 bis 9,
**dadurch gekennzeichnet, daß**
die Testplatine (1, 40) aus einem durchsichtigen Material besteht und an der anderen Seite der Testplatine ein Bild- oder Filmaufnahmegerät (5) derart angeordnet ist, daß dieses durch die Testplatine (1, 40) hindurch die Bewegungen der Strömungstestelemente (2, 10 bis 13, 41, 51) aufzuzeichnen imstande ist.

11. Testplatine nach einem der Ansprüche 7 bis 10,
**dadurch gekennzeichnet, daß**
an der Testplatine (40) Markierungen (42) zur Auswertung der Bewegungen der Strömungstestelemente (41) angebracht sind.

12. Testplatine nach Anspruch 8,
**dadurch gekennzeichnet, dass**
eine Sensorplatte, welche die Lage der Modellbauelemente festzustellen imstande ist, eine Fläche der Testplatine bildet.

## Claims

1. Method for determining flow conditions for the heating gas in reflow soldering devices, in which
- a test board (1, 40) without any solder paste and bearing flow test elements (2, 10 to 13, 41, 51) without any solder paste is transported through the reflow soldering device, and
- movements of the flow test elements (2, 10 to 13, 41, 51) are evaluated in order to determine the flow conditions.

2. Method according to Claim 1, in which the flow test elements used are model components (41, 51), the shape of which corresponds to that of electrical components and the weight of which leads to a static friction force on the test board (1, 40) corresponding to the wet-adhesion force exerted on the electrical components by solder paste.

3. Method according to Claim 1, in which the flow test elements (2, 10 to 13, 41, 51) used are flags which can be rotated by the heating gas.

4. Method according to one of Claims 1 to 3, in which the movements of the flow test elements (2, 10 to 13, 41, 51) while the test board is being transported through the reflow soldering device are recorded by means of an image- or film-recording device (5).

5. Method according to Claim 4, in which an image- or film-recording device (5) which is secured to the test board (1, 40) is used.

6. Method according to Claim 2, in which the movements of the model components are evaluated by means of a sensor plate which forms a surface of the test board and is able to determine the position of the model components.

7. Test board (1, 40) having flow test elements (2, 10 to 13, 41, 51) arranged on one side for determining the flow conditions of the heating gas in reflow soldering devices, **characterized in that** the test board (1, 40) does not have any solder paste and bears flow test elements (2, 10 to 13, 41, 51) which do not have any solder paste and the movements of which during transport through a reflow soldering device can be evaluated in order to determine the flow conditions.

8. Test board according to Claim 7, **characterized in that** as flow test elements it has model components (41, 51), the shape of which corresponds to that of electrical components and the weight of which leads to a static friction force on the test board (1, 40) corresponding to the wet-adhesion force exerted on the electrical components by solder paste.

9. Test board according to Claim 7, **characterized in that** as flow test elements it has flags (2, 10 to 13) which can be rotated by the heating gas.

10. Test board according to one of Claims 7 to 9, **characterized in that** the test board (1, 40) consists of a transparent material, and an image- or film-recording device (5) is arranged on the other side of the test board, in such a manner that this recording device is able to record the movements of the flow test elements (2, 10 to 13, 41, 51) through the test board (1, 40).

11. Test board according to one of Claims 7 to 10, **characterized in that** markings (42) for evaluating the movements of the flow test elements (41) are applied to the test board (40).

12. Test board according to Claim 8, **characterized in that** a sensor plate which is able to determine the position of the model components forms one surface of the test board.

## Revendications

1. Procédé de détermination des conditions d'écoulement du gaz chaud dans des machines à braser par refusion, dans lequel
- on transporte une platine (1, 40) de test, exempte de pâte de brasure et ayant des éléments (2,10 à 13, 41, 51) de test d'écoulement exempts de pâte de brasure dans la machine à braser par refusion et
- on évalue des déplacements des éléments (2, 10 à 13, 41, 51) de test d'écoulement pour déterminer les conditions d'écoulement.

2. Procédé suivant la revendication 1, dans lequel on utilise, comme élément de test d'écoulement, des éléments (41, 51) de formation de modèle qui correspondent dans leur forme à des composants électriques et qui ont un poids qui se traduit par une force de frottement par adhérence sur la platine (1, 40) de test correspondant à la force de collage en voie humide appliquée par la pâte à braser sur les composants électriques.

3. Procédé suivant la revendication 1, dans lequel on utilise, comme élément (2, 10 à 13, 41, 51) de test d'écoulement du gaz chaud, des drapeaux tournants.

4. Procédé suivant l'une des revendications 1 à 3, dans lequel on enregistre les mouvements des éléments (2, 10 à 13, 41, 51) de test d'écoulement pendant le transport de la platine de test dans la machine à braser par refusion au moyen d'un appareil (5) d'enregistrement d'image ou de film.

5. Procédé suivant la revendication 4, dans lequel on utilise un appareil (5) d'enregistrement d'image ou de film, qui est fixé à la platine (1, 40) de test.

6. Procédé suivant la revendication 2 dans lequel on évalue les mouvements des éléments formant un modèle au moyen d'une plaque de capteur formant une surface de la platine de test et en mesure de constater la position des éléments formant un modèle.

7. Platine (1, 40) de test comprenant des éléments (2, 10 à 13, 41, 51) de test d'écoulement disposés sur une face et destinés à déterminer les conditions d'écoulement du gaz chaud dans des machines à braser à refusion, **caractérisée en ce que** la platine (1, 40) de test est exempte de pâte de brasage et porte des éléments (2, 10 à 13, 41, 51) de test d'écoulement exempts de pâte de brasage, dont on peut évaluer des mouvements pendant le transport dans une machine à braser par refusion pour déterminer les conditions d'écoulement.

8. Platine de test suivant la revendication 7,
**caractérisée en ce qu'**elle a des éléments (41, 51) de formation de modèle qui correspondent dans leur forme à des composants électriques et qui ont un poids qui se traduit par une force de frottement par adhérence sur la platine (1, 40) de test correspondant à la force de collage en voie humide appliquée par la pâte à braser sur les composants électriques.

9. Platine de test suivant la revendication 7,
**caractérisée en ce qu'**elle a comme élément de test d'écoulement du gaz chaud, des drapeaux (2, 10 à 13) tournants.

10. Platine suivant l'une des revendications 7 à 9,
**caractérisée en ce que** la platine (1, 40) de test est en un matériau transparent et il est disposé, sur l'autre face de la platine de test, un appareil (5) d' enregistrement d'image ou de film de manière à ce que celui-ci soit en mesure d'enregistrer, à travers la platine (1, 40) de test, les mouvements des éléments (2, 10 à 13, 41, 51) de test d'écoulement.

11. Platine suivant l'une des revendications 7 à 10,
**caractérisée en ce qu'**il est apposé sur la platine (40) de test des repères (42), pour évaluer les mouvements des éléments (41) de test d'écoulement.

12. Platine suivant la revendication 8,
**caractérisée en ce qu'**une plaque de capteur, qui est en mesure de constater la position des éléments formant un modèle, forme une surface de la platine de test.
